# EUROPÄISCHE PATENTSCHRIFT

(11) **EP 1 543 563 B1**
(45) Veröffentlichungstag und Bekanntmachung des Hinweises auf die Patenterteilung: **03.05.2017**
(21) Anmeldenummer: 03740057.9
(22) Anmeldetag: 03.06.2003
(51) Int. Cl.: H01L 29/861

(54) **HALBELEITERDIODE UND VERFAHREN ZU IHRER HERSTELLUNG**
SEMICONDUCTOR DIODE AND METHOD FOR THE PRODUCTION THEREOF
DIODE A SEMI-CONDUCTEUR ET SON PROCEDE DE PRODUCTION

(30) Priorität: 20.09.2002 DE 10243813
(43) Veröffentlichungstag der Anmeldung: 22.06.2005
(73) Patentinhaber: ROBERT BOSCH GMBH, 70442 Stuttgart (DE)
(72) Erfinder: KEPPELER, Dana, 89077 Ulm (DE); GOERLACH, Alfred, 72127 Kusterdingen (DE); SPITZ, Richard, 72766 Reutlingen (DE)
(86) Internationale Anmeldenummer: PCT/DE2003/001809
(87) Internationale Veröffentlichungsnummer: WO 2004/030107

(56) Entgegenhaltungen:
- WO-A-01/13434
- DE-A- 4 320 780
- US-A1- 2002 070 380
- US-A1- 2002 072 207
- US-A1- 2002 127 890

## Beschreibung

### Stand der Technik

Die Erfindung-betrifft eine Halbleiteranordnung nach Anspruch 1 sowie ein Verfahren zu ihrer Herstellung nach Anspruch 5.

Aus DE 43 20 780 A1 ist eine Halbleiterdiode bekannt, bei der das Dotierprofil an den Rändern der Diode von dem Dotierprofil in der Mitte abweicht. Damit lässt sich erreichen, dass bei Betrieb in Sperrrichtung der Spannungsdurchbruch, der bei der Durchbruchsspannung UZ einsetzt, nur im mittleren Teil der Diode und nicht am Rande auftritt. Dies hat eine hohe Robustheit im Betrieb zur Folge, da an den Chiprändern kein Lawinendurchbruch auftreten kann.

Aus DE 43 20 780 A1 ist weiter eine Halbleiteranordnung mit einem pn- Übergang, insbesondere eine Diode, bekannt, die als Chip mit einem Randbereich ausgebildet ist, die aus einer ersten Schicht eines ersten Leitfähigkeitstyps und einer zweiten Schicht des entgegengesetzten Leitfähigkeitstyps aufgebaut ist, wobei die zweite Schicht aus mindestens zwei Teilschichten besteht. Die erste Teilschicht weist dabei eine erste Dotierstoffkonzentration auf, während die zweite Teilschicht eine zweite Dotierstoffkonzentration aufweist, die geringer als die erste Dotierstoffkonzentration ist. Beide Teilschichten bilden mit der ersten Schicht einen pn-Übergang, wobei der pn-Übergang der ersten Schicht mit der ersten Teilschicht ausschließlich im Inneren des Chips und der pn-Übergang zwischen der ersten Schicht und der zweiten Teilschicht im Randbereich des Chips ausgebildet sind.

Aus der US 2002/0070380 A1 sind Halbleiteranordnungen mit pn-Übergängen bekannt, bei denen im Inneren der Halbleiteranordnung eine andere pn-Struktur vorliegt, als am Rand. Die Halbleiteranordnungen umfassen mehrere Schichten mit unterschiedlichen Dotierungen, wobei in den einzelnen Schichten p- und n-Dotierungen mit unterschiedlicher Konzentration von Dotierstoffen vorlegen. Dabei ist infolge der höheren Dotierung im Inneren der Halbleiteranordnung ein starker pn-Übergang vorhanden. Damit wird sichergestellt, dass ein möglicherweise auftretender Durchbruch im Inneren der Halbleiteranordnung stattfindet.

Aus der US 2002/072207 A1 sind Verfahren zur Herstellung von Halbleiteranordnungen bekannt, bei denen eine Vielzahl von Schichten mit unterschiedlicher Dotierstoffkonzentration hergestellt werden. Die Halbleiteranordnungen sollen dabei so aufgebaut werden, dass Unterschiede zwischen dem Halbleiterinneren und dem Rand der Halbleiteranordnung entstehen.

### Vorteile der Erfindung

Die bekannte Halbleiteranordnung zeichnet sich zwar durch eine hohe Robustheit im Betrieb aus, da durch die besondere Ausgestaltung des Dotierprofils im Randbereich bei Betrieb der Halbleiteranordnung in Sperrrichtung kein Spannungsdurchbruch im Randbereich auftritt. Nachteilig ist jedoch, dass die bekannte Halbleiteranordnung infolge ihrer niedrig dotierten Mittelschicht einen relativ hohen elektrischen Widerstand aufweist. Dieser hohe elektrische Widerstand verursacht einen unerwünschten Spannungsabfall, der sich insbesondere im Durchbruchsbetrieb störend auswirkt. Dies ist umso ausgeprägter, je höher die Durchbruchsspannung UZ der Halbleiteranordnung ist. Deshalb ist die bekannte Halbleiteranordnung für höhere Durchbruchsspannungen, die beispielsweise für den Einsatz im 42 Volt Bordnetz benötigt werden, nicht geeignet. Die erfindungsgemässe Halbleiteranordnung vermeidet diesen Nachteil durch ihren besonderen Schichtaufbau. Sie eignet sich daher vorzüglich für den Einsatz in Bordnetzen, die mit einer höheren Spannung als 24 Volt arbeiten. Weiterhin zeichnet sich die erfindungsgemäße Halbleiteranordnung durch einen geringeren Sperrstrom, ein robusteres Verhalten bei Temperaturwechseln, sowie eine höhere Impulsfestigkeit aus. Der geringere Sperrstrom und die höhere Impulsfestigkeit ist darauf zurückzuführen, dass sich bei der erfindungsgemäßen Halbleiteranordnung die Raumladungszone am Randbereich der Halbleiteranordnung 10 weiter ausdehnt als in deren mittleren Bereich, wodurch die elektrische Feldstärke an der Oberfläche des Randbereichs herabgesetzt ist. In Folge der geringen Sperrströme kann gegebenenfalls auch auf ein Entfernen der Damagezone, beispielsweise durch Ätzen, verzichtet werden.

### Zeichnung

Ausführungsbeispiele der Erfindung sind in den Zeichnungen dargestellt und werden in der nachfolgenden Beschreibung näher erläutert. Dabei zeigt Figur 1 eine bekannte Halbleiteranordnung in einer schematischen Schnittdarstellung, Figur 2 ein Ausführungsbeispiel einer erfindungsgemäßen Halbleiteranordnung in einer schematischen Schnittdarstellung, Figur 3 ein zweites Beispiel einer nicht erfindungsgemäßen Halbleiteranordnung, Figur 4 (Figur 4a, Figur 4b) einen Vergleich der Sägegrabengeometrie zwischen einer bekannten (Figur 4a) und der erfindungsgemäßen (Figur 4b) Halbleiteranordnung im Ausschnitt in einer Schnittdarstellung, Figur 5 in einem Diagramm die schematische Darstellung der Dotierprofile von bekannter und erfindungsgemäßer Halbleiteranordnung im Vergleich entlang Schnitt AB, Figur 6 ein weiteres Beispiel einer nicht zur Erfindung gehörenden Halbleiteranordnung, bei dem aneinander grenzende Schichten der Halbleiteranordnung aus dem gleichen Dotierungstyp sind.

### Beschreibung der Ausführungsbeispiele.

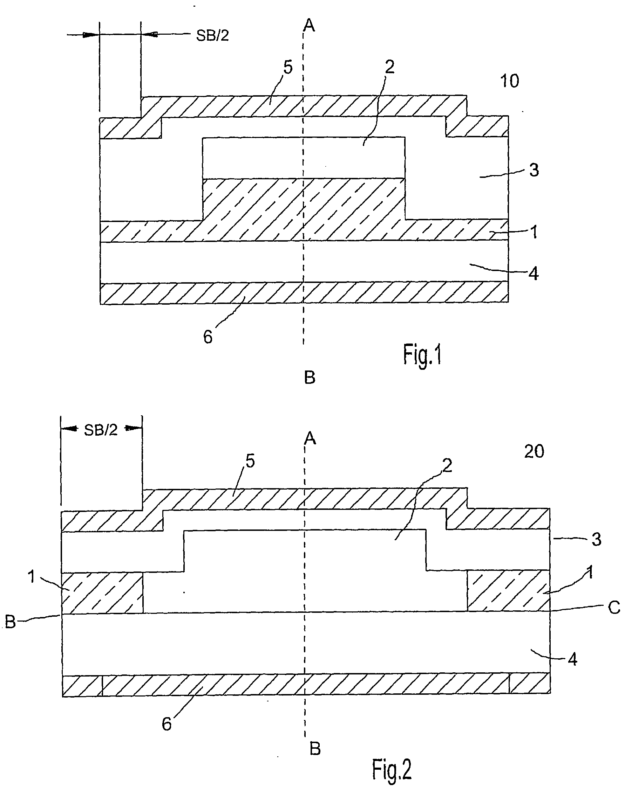

Figur 1 zeigt zunächst eine bekannte Halbleiteranordnung 10, die aus mehreren unterschiedlich dotierten Schichten 1, 2,3, 4 besteht. Dabei sind die Schichten 1,2, 4 mit unterschiedlicher Konzentration n-dotiert, während es sich bei der Schicht 3 um eine p-dotierte Schicht handelt. Die äußeren Oberflächen der Schichten 3 und 4 sind mit Kontaktschichten 5,6 aus Metall belegt. Bei dieser Halbleiteranordnung 10 handelt es sich beispielsweise um eine Diode. Die p-dotierte Schicht 3 bildet mit den n-dotierten Schichten 1, 2 einen pn-Übergang.

Da sich die höher n-dotierte Schicht 2 im Wesentlichen nur in der Mitte der Halbleiteranordnung befindet, unterscheidet sich das Dotierprofil an den Rändern der Diode von dem Dotierprofil in dem mittleren Bereich der Diode. Bei Betrieb der Diode in Sperrrichtung tritt daher bei einer Durchbruchsspannung UZ ein Spannungsdurchbruch im Wesentlichen nur im mittleren Bereich der Diode und nicht in ihrem Randbereich auf. Dies hat zwar eine hohe Robustheit im Betrieb zur Folge, da im Randbereich der Diode kein Lawinendurchbruch auftreten kann. Besonders nachteilig für Anwendungen der Diode bei höheren Spannungen ist jedoch, dass die Diode infolge der niedrig n-dotierten Schicht 1 einen vergleichsweise hohen elektrischen Widerstand aufweist. Dieser Widerstand verursacht einen unerwünschten Spannungsabfall, der sich vor allem im Durchbruchsbetrieb störend auswirkt. Dies ist umso ausgeprägter, je höher die Durchbruchsspannung UZ der Diode ist. Deshalb ist eine derartige herkömmliche Diode für höhere Durchbruchsspannungen, wie sie zum Beispiel für den Einsatz in Bordnetzen mit 42 V Betriebsspannung benötigt werden, nicht geeignet. Die vorgeschlagene Erfindung beseitigt diesen Nachteil.

Figur 2 zeigt als erstes Ausführungsbeispiel der Erfindung in einer schematischen Schnittdarstellung eine aus mehreren Teilschichten unterschiedlicher Dotierung bestehende Halbleiteranordnung 20. Ausgegangen wird von einem schwach n-dotierten Halbleitersubstrat, das eine erste Teilschicht 1 bildet. Im mittleren Bereich dieses Halbleitersubstrats ist von der Oberseite her eine zweite n-dotierte Teilschicht 2 eingebracht, die sich jedoch nicht bis in die Randbereiche der Teilschicht 1 erstreckt. Ebenfalls von der Oberseite aus erstreckt sich eine dritte p-dotierte Teilschicht 3 bis an die n-dotierte Teilschicht 2 im mittleren Bereich und bis an die n-dotierte Teilschicht 1 im Randbereich der Halbleiteranordnung 20. Die Grenzbereiche zwischen den Teilschichten 3 und 2, beziehungsweise 3 und 1 bilden die pn-Übergänge. Mit 5 und 6 sind metallische Kontaktschichten bezeichnet, die auf die äußeren Oberflächen der Teilschichten 3 und 4 aufgebracht sind. Da die n-Dotierungskonzentration der Teilschicht 2 größer ist als die n-Dotierungskonzentration der Teilschicht 1, ist die Durchbruchsspannung UZM des im mittleren Bereich der Halbleiteranordnung 20 zwischen den Teilschichten 3 und 2 liegenden pn-Übergangs 3-2 kleiner als die Durchbruchsspannung UZR des im Randbereich der Halbleiteranordnung 20 liegenden pn-Übergangs 3-1 zwischen den Teilschichten 3 und 1. Somit ist hier sichergestellt, dass ein Durchbruch auch bei der erfindungsgemäßen Halbleiteranordnung nur im mittleren Bereich der Halbleiteranordnung 20 und nicht an deren Randbereich erfolgen kann. Infolge der Ladungsneutralität dehnt sich die Raumladungszone in dem Randbereich der Halbleiteranordnung 20 weiter aus als in deren mittleren Bereich. Dies hat zur Folge, dass die elektrische Feldstärke an der Oberfläche des Randbereichs der Halbleiteranordnung 20 herabgesetzt ist. Daraus ergeben sich in vorteilhafter Weise ein geringerer Sperrstrom und eine höhere Impulsfestigkeit. In Folge des geringen Sperrstroms kann gegebenenfalls in vorteilhafter Weise auch auf ein Entfernen der Damagezone, beispielsweise durch einen zusätzlichen Ätzvorgang, verzichtet werden. Von der Rückseite der Halbleiteranordnung 20 her dehnt sich eine stark n-dotierte weitere Teilschicht 4 bis an n-dotierte Teilschicht 2 und die schwach n-dotierte Teilschicht 1 aus. Im Gegensatz zu der in Figur 1 dargestellten herkömmlichen Halbleiteranordnung 10 verbleibt zwischen den jeweils n-dotierten Teilschichten 3 und 4 nur in einem schmalen Randbereich eine schwach n-dotierte Teilschicht 1. Im mittleren Bereich der Halbleiteranordnung 20 ist daher die n-Dotierkonzentration höher als die Grunddotierung der ersten Teilschicht 1 der Halbleiteranordnung. Durch das erfindungsgemäße Vermeiden einer schwach n-dotierten Teilschicht 1 zwischen den Teilschichten 3 und 4 bei der Halbleiteranordnung 20 wird ein deutlich geringerer Bahnwiderstand als bei einer herkömmlichen Halbleiteranordnung erzielt. Im Falle eines Durchbruchs ergibt sich daraus, in vorteilhafter Weise, ein geringerer Spannungsabfall.

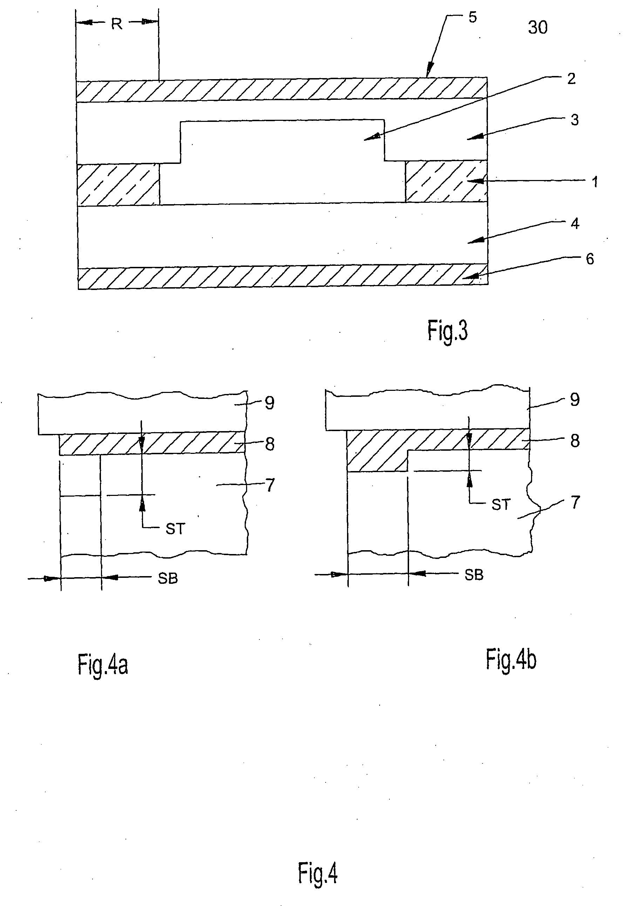

Ein weiteres Beispiel einer nicht erfindungsgemäßen Halbleiteranordnung ist in einer schematischen Querschnittdarstellung in Figur 3 dargestellt. Diese Halbleiteranordnung 30 weist, im Unterschied zu der in Figur 2 dargestellten Halbleiteranordnung 20, in ihrem Randbereich keine Vertiefung auf. Dies ermöglicht, bei gleicher Gesamtdicke der Halbleiteranordnungen 20,30, das Erreichen einer noch höheren Durchbruchsspannung UZR am Randbereich der Halbleiteranordnung 30 mit allen sich daraus ergebenden Vorteilen, wie geringer Sperrstrom und höhere Impulsfestigkeit.

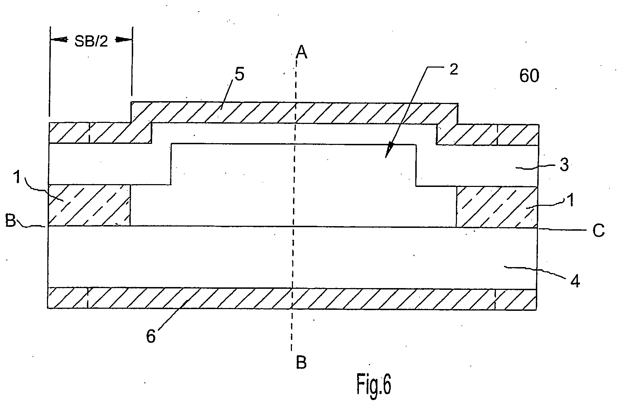

Ein weiteres Beispiel einer nicht erfindungsgemäßen Halbleiteranordnung ist in Figur 6 dargestellt. Im Unterschied zu den Halbleiteranordnungen 20 und 30 in Figur 2 und Figur 3, besteht die Teilschicht 2 aus demselben Dotierungstyp wie die Teilschicht 3.

Weiterhin sind Ausführungsbeispiele denkbar, bei denen das Ausgangsmaterial der Teilschicht 1 nicht homogen dotiert ist. Diese Teilschicht 1 wird vielmehr als Epitaxieschicht auf einer bereits hochdotierten Teilschicht 4 aufgebracht.

Im Folgenden wird, unter Bezug auf Figur 2, ein besonders vorteilhaftes Herstellungsverfahren zur Herstellung einer Halbleiteranordnung mit dem in Figur 2 dargestellten Schichtaufbau beschrieben. Als Beispiel wird die Herstellung einer Diode mit einer Zener-Spannung UZ von circa 50 Volt beschrieben.

Selbstverständlich können mit dem erfindungsgemäßen Verfahren auch Dioden hergestellt werden, die für größere oder kleinere Zener-Spannungen ausgelegt sind. So kann beispielsweise durch eine einfache Variation des Dotierungsprofils eine Zener-Spannung von etwa 20 Volt realisiert werden. Ausgegangen wird von einem aus Silizium bestehenden Halbleitersubstrat mit einer Dicke von rund 180 zum und einer n-Dotierung von circa 1*1016 cm∼3, das die erste Teilschicht 1 der Halbleiteranordnung 20 bildet. Diese Teilschicht 1 wird auf der Ober-und Unterseite mit Phosphor dotiert. Dies kann auf vorteilhafte Weise mittels Ionenimplantation, Dotiergläsern, Dotierfolien, oder, besonders zweckmäßig, mittels einem als APCVD- Verfahren (Atmospheric Pressure Chemical Vapour Deposition) bezeichneten Verfahren erfolgen. Besonders einfach und wirtschaftlich kann die Dotierung der Teilschicht 1 mit Phosphoratomen auch in einer Gasphase erfolgen. Dazu wird die Teilschicht 1 bei einer erhöhten Temperatur einer Atmosphäre von POC13 ausgesetzt.

Dafür eignen sich Temperaturen etwa zwischen 830 C und 890 C, insbesondere eine
Temperatur von 870°C. Nach dem Dotiervorgang werden die auf dem Halbleitersubstrat verbliebenen Glasschichten durch einen Ätzvorgang mittels verdünnter Flusssäure entfernt. Werden für das Dotieren Dotiergläser verwendet, so folgt nach dem Abscheiden der dotierten Gläser ein sogenannter Eintreibschritt, um die Dotieratome in das zu dotierende Halbleitersubstrat, also die erste Teilschicht 1, einzutreiben. Als besonders günstig hat sich ein Eintreibschritt von 20 bis 40 Minuten, insbesondere 30 Minuten erwiesen. Dieser Eintreibschritt wird zweckmäßig bei einer erhöhten Temperatur von etwa 1200 bis 1300, insbesondere von 1265 °C, durchgeführt. Nach diesem Dotierungsschritt beträgt das Integral über die Konzentration von Phosphoratomen, die Dosis, auf jeder dotierten Seite der ersten Teilschicht 1 etwa 2*10¹⁶cm⁻² Die Eindringtiefe der Phosphoratome in das n-dotierte Halbleitermaterial der ersten Teilschicht 1 beträgt ungefähr 5-15 Mikrometer. Im Falle einer PoCl3-Gasphasenbelegung weniger als etwa 1 Mikrometer. Anschließend wird die Oberseite der dotierten ersten Teilschicht 1 strukturiert. Dies kann in besonders vorteilhafter Weise durch Sägeschnitte in die Oberseite mittels einer Diamantsäge oder wasserunterstütztes Laserschneiden erfolgen. Die Sägetiefe ST (Figur 4) beträgt etwa 1-35 Mikrometer. Im Regelfall wird die Sägetiefe ST zweckmäßig derart gewählt, dass sie größer ist als die Eindringtiefe der Phosphoratome in die Oberfläche der Teilschicht 1. Durch die geeignete Wahl der Sägetiefe ST kann die laterale Ausdiffusion der Phosphorschicht, beziehungsweise die Phosphorkonzentration und damit die Durchbruchsfeldstärke im Randbereich der Halbleiteranordnung 20, bei dem anschließenden Diffusionsvorgang maßgeblich beeinflusst werden Die Breite SB des verwendeten Sägeblatts richtet sich auch nach der gewünschten Sägetiefe und dem anschließenden Diffusionsprozess. Typisch sind Sägebreiten SB (Figur 1,2, 4b, 6) in der Größenordnung von ca. 300 Mikrometer. Nach diesem mechanischen Strukturierungsprozess findet ein weiterer Diffusionsprozess statt, bei dem die n-Dotierstoffe in das Halbleitersubstrat eingetrieben werden. Dieses Eintreiben findet bevorzugt in einer oxidierenden Atmosphäre, zweckmäßig in trockenem oder auch nassem Sauerstoff statt. Als Abwandlung ist auch die Diffusion in einer Atmosphäre aus reinem Stickstoff oder einem Stickstoff- Sauerstoffgemisch möglich. Auch dieser Diffusionsvorgang wird bei einer hohen Temperatur zwischen 1200 und 1300 C, insbesondere bei einer Temperatur von 1265 C durchgeführt. Dieser Temperatur wird das Halbleitersubstrat für etwa 140 Stunden ausgesetzt. Während des Diffusionsvorgangs ist das Halbleitersubstrat auf einem geeigneten Träger angeordnet, der vorzugsweise aus SiC oder einem ähnlich temperaturfesten Material besteht. Nach dem zuvor beschriebenen Diffusionsvorgang wird die dabei auf der Oberfläche des Halbleitersubstrats entstandene Schicht aus SiO2 wieder abgeätzt. Um die Effizienz des Verfahrens zu steigern, können grundsätzlich auch mehrere Halbleitersubstrate zu einem Stapel aufgeschichtet und gemeinsam dem Diffusionsprozess ausgesetzt werden. Zwischen die einzelnen Halbleitersubstrate werden dabei zweckmäßig sogenannte Neutralfolien (neutral preforms) angeordnet. Diese Neutralfolien enthalten Trennmittel, wie beispielsweise Körner aus SiC oder Al₂O₃, und verhindern so ein Zusammenkleben der Halbleitersubstrate. Nach erfolgreicher Beendigung des Diffusionsprozesses werden die einzelnen Halbleitersubstrate mittels verdünnter Flusssäure wieder voneinander getrennt. In einem anschließenden weiteren Diffusionsprozess wird nun eine weitere Teilschicht 3 eingebracht, die p-dotiert ist. Gleichzeitig soll die Konzentration der Dotieratome in der Teilschicht 4 noch weiter erhöht werden. Grundsätzlich sind dafür alle dem Fachmann geläufigen Dotierverfahren geeignet. Besonders vorteilhaft ist jedoch die Verwendung sogenannter Dotierfolien. Dabei werden abwechselnd p- und n-Dotierfolien zusammen mit den Halbleitersubstraten wiederum zu Stapeln geschichtet und zusammen erhitzt. Dieser Prozessschritt nimmt etwa eine Zeit von 30 Stunden bei einer Temperatur von 1265 °C in Anspruch. Besonders vorteilhaft bei dieser Verfahrensdurchführung ist dabei, dass die Teilschichten 3 und 4 gemeinsam in einem einzigen Diffusionsschritt erzeugt werden können. Wie oben schon beschrieben, werden nach Beendigung dieses Diffusionsschrittes die einzelnen Halbleitersubstrate mittels verdünnter Flusssäure wieder voneinander getrennt.

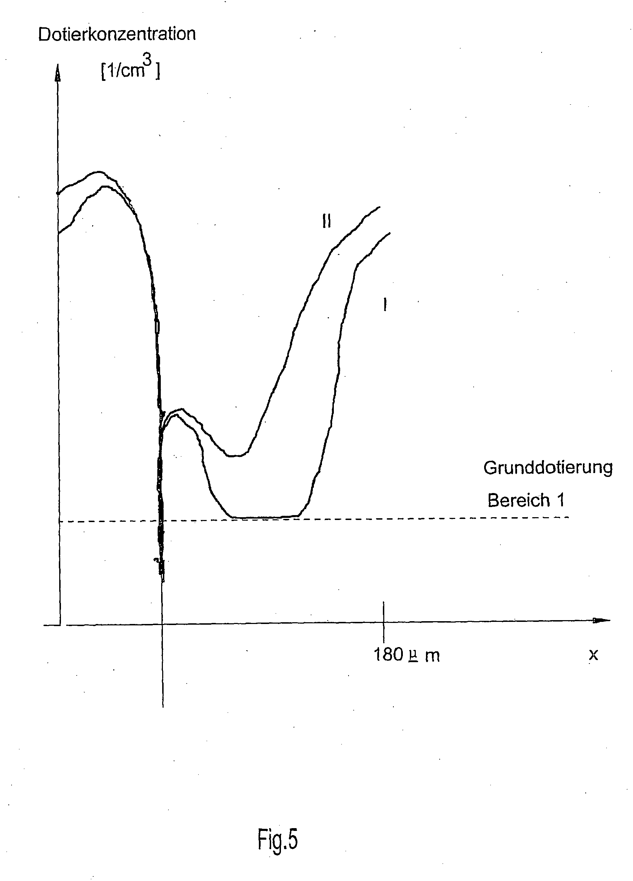

Das Diffusionsprofil im mittleren Bereich (vergleiche Schnitt AB in Figur 2) einer auf die zuvor beschriebene Weise hergestellten Diode ist in dem Diagramm in Figur 5 (Kurvenverlauf II) dargestellt. Dieses Diagramm zeigt die Dotierkonzentration in Abhängigkeit von dem Abstand x. Als Besonderheit lässt sich hervorheben, dass die minimale Dotierkonzentration bei dieser Diode größer ist als die Grunddotierung des Halbleitersubstrats, also der Dotierung der ersten Teilschicht 1 in Figur 2 oder 3.

Im Gegensatz zu der herkömmlichen Struktur einer Halbleiteranordnung nach Figur 1, bei der das Einsägen erst nach der Diffusion der n-dotierten Teilschicht 2 erfolgt, kann bei der erfindungsgemäßen Lösung die Sägetiefe ST geringer gewählt werden als bei der herkömmlichen Halbleiteranordnung. Da deshalb der noch verbleibende Anteil der ersten Teilschicht 1 größer ist als bei der herkömmlichen Lösung, können im Randbereich der erfindungsgemäßen Halbleiterstruktur höhere Durchbruchsspannungen UZR erzielt werden. Wenn die Sägetiefe ST, wie bei der herkömmlichen Halbleiterstruktur, nicht klein genug gewählt werden kann, weil das Einsägen erst nach der ersten Diffusionsbehandlung der n-dotierten Teilschicht 2 erfolgt, diffundiert die p-dotierte dritte Teilschicht 3 mit der n-dotierten Teilschicht 4 im Randbereich der Halbleiteranordnung zusammen. Dies vermindert jedoch die Durchbruchsspannung UZR stark.

In einer weiteren alternativen Ausgestaltung des erfindungsgemäßen Verfahrens kann die zuvor beschriebene gemeinsame Diffusion der p-dotierten Teilschicht 3 und der n-dotierten Teilschicht 4 auch in zwei Teilschritte aufgespalten werden. Dabei werden in dem ersten Teilschritt zunächst die Dotierstoffe eingebracht und in einem zweiten Teilschritt dann weiter eingetrieben. Wiederum können dabei die oben schon beschriebenen Dotier- und Diffusionsverfahren eingesetzt werden. Insbesondere können die Stapeldiffusion und die Diffusion in Trägern (boots) oder eine Kombination von beiden Verfahren angewendet werden.

Anschließend wird das Halbleitersubstrat auf seiner Oberseite und seiner Unterseite mit je einer Kontaktschicht 5, 6 aus Metall versehen (Figur 2). Vorzugsweise wird dabei allerdings eine komplexe Schichtenfolge aus mehreren Metallen aufgebracht. Beispielsweise eignet sich die Kombination Chrom, Nickel, Silber besonders gut.

Nach der Metallisierung der Kontaktbereiche der Halbleitersubstrate werden die einzelnen Halbleiteranordnungen, in dem beschriebenen Ausführungsbeispiel also Dioden, zum Beispiel durch Sägen mit einer Diamantsäge voneinander getrennt. Üblich sind dabei Sägeblätter mit einer Breite von 40 Mikrometer. Durch diesen Sägevorgang erhält man einzelne Dioden, die üblicherweise noch mit einem Gehäuse versehen werden. Die Diode wird in das Gehäuse eingelötet und durch dieses geschützt.

Das Trennen der Halbleitersubstrate mittels einer Diamantsäge, kann, bei ungünstigen Sägebedingungen, die beispielsweise von der Körnung der Diamantsplitter der Säge, der Drehzahl und dem Vorschub abhängig sind, gestörte Kristallzonen im Randbereich der Halbleiteranordnung 20, 30,60 hervorrufen. Diese gestörten Kristallzonen wiederum geben Anlass zu unerwünschten zusätzlichen Sperrströmen bei dem Betrieb der Halbleiteranordnung. Üblicherweise werden daher die gestörten Kristallzonen in einem zusätzlichen Verfahrensschritt, beispielsweise durch Ätzen, entfernt.Bei der erfindungsgemäßen Halbleiteranordnung 20, 30, 60 ist aber die Durchbruchsspannung UZR im Randbereich der Halbleiteranordnung deutlich höher als bei einer herkömmlichen Halbleiteranordnung, wie beispielsweise jener nach Figur 1. Daher ist auch das Verhältnis von Durchbruchsspannung UZR am Randbereich der Halbleiteranordnung zu der Durchbruchsspannung UZM im mittleren Bereich der Halbleiteranordnung wesentlich höher. Dies hat zur Folge, dass bei der erfindungsgemäß ausgebildeten Halbleiteranordnung der von den eventuell gestörten Randbereichen stammende Sperrstrom wesentlich geringer ist. Auf das Entfernen der gestörten Kristallzonen (Damagezonen) im Randbereich der erfindungsgemäßen Halbleiteranordnung kann daher in den meisten Fällen auch verzichtet werden. Dies führt zu einer Vereinfachung des Herstellungsverfahrens und damit zu einer weiteren Kostensenkung.

Werden die gestörten Randbereiche aber doch entfernt, was im Folgenden beschrieben wird, lässt sich ein noch wesentlich geringerer Sperrstrom erreichen. Für die Entfernung der gestörten Randbereiche der Halbleiteranordnung bieten sich nasschemische Ätzverfahren unter Verwendung von KOH, Gasphasenätzen, oder ähnliche Verfahren an. Da im Gegensatz zu herkömmlichen Halbleiteranordnungen nur sehr flache Sägegräben notwendig sind, bietet sich aber insbesondere ein nasschemisches Ätzverfahren unter Verwendung von KOH oder einer vergleichbaren Ätzlösung an. Bei einer herkömmlichen Halbleiteranordnung nach Figur 1 ist der erforderliche Sägegraben besonders tief und schmal. Beispielsweise beträgt das Verhältnis von Sägebreite SB zu Sägetiefe ST 2,5. Bei der erfindungsgemäßen Halbleiteranordnung 20 nach Figur 2 dagegen, beträgt das Verhältnis von Sägebreite SB zu Sägetiefe ST beispielsweise 15. Diese Verhältnisse sind in Figur 4, mit den Teilfiguren Figur 4a und Figur 4b zeichnerisch dargestellt. In beiden Figuren ist jeweils ein vergrößerter Ausschnitt aus einem Kantenbereich einer Halbleiteranordnung im Querschnitt dargestellt. Das Halbleitersubstrat ist mit 7 bezeichnet. Mit Bezugsziffer 8 ist eine Lotschicht bezeichnet. Bezugsziffer 9 kennzeichnet eine beispielsweise aus Kupfer bestehende Wärmesenke. Die Sägebreite ist mit der Buchstabenkombination SB, die Sägetiefe mit ST bezeichnet. Eine herkömmliche Halbleiteranordnung ist in Figur 4a dargestellt, während Figur 4b eine erfindungsgemäße Halbleiteranordnung zeigt. Wie Figur 4b deutlich zeigt, füllt bei der erfindungsgemäßen Halbleiteranordnung die Lotschicht 8 den durch Sägebreite SB und Sägetiefe ST gekennzeichneten Sägegraben vollständig aus. Dies bietet den Vorteil, dass bei einer anschließenden nasschemischen Ätzung die Kontaktschicht 5 oder das darunter liegende Halbleitermaterial im Bereich des Sägegrabens nicht mehr angegriffen werden, weil sie von der Lotschicht 8 vollständig abgedeckt sind. Darüber hinaus bietet ein vollständig mit duktilem Lotmaterial gefüllter Sägegraben den Vorteil, dass das Halbleitersubstrat mechanisch entlastet ist, wenn infolge von Temperaturwechselspannungen Druck- und/oder Scherkräfte auf die Halbleiteranordnung einwirken. Zudem wird die Wärmeableitung aus dem Halbleitersubstrat weiter verbessert. Die vorbeschriebenen Vorteile sind mit der in Figur 4a gezeigten Ausgestaltung einer herkömmlichen Halbleiteranordnung dagegen nicht zu erzielen.

Ein weiteres Beispiel einer nicht erfindungsgemäßen Halbleiteranordnung 30 ist in Figur 3 schematisch in einem Querschnitt dargestellt. Dabei wird auf eine Vertiefung des Halbleitersubstrats im Randbereich völlig verzichtet. Dies ermöglicht, bei gleicher Dicke des Halbleitersubstrats wie bei der Halbleiteranordnung 20 in Figur 2, eine noch höhere Durchbruchsspannung UZR im Randbereich. Dies führt zu weiteren Vorteilen, wie geringer Sperrstrom und höhere Impulsfestigkeit. Strukturaufbau und Herstellungsverfahren sind praktisch identisch wie bei dem oben anhand von Figur 2 beschriebenen Ausführungsbeispiel der Erfindung. Die Strukturierung der n-dotierten Schicht 2 kann aber vorteilhaft auch durch Verfahrensschritte erfolgen, die aus der konventionellen Fotolithografie und Planartechnik bekannt sind. Diese Verfahrensschritte umfassen insbesondere die Schritte thermische Oxidation, Belackung mit Fotolack, Vorhärtung, Belichtung und Aushärten des Fotolacks, Ätzen der Kontaktfenster und Strippen des Fotolacks. Bei hinreichend dicken thermischen Oxidschichten kann die Oxidschicht vorteilhaft auch als Diffusionsbarriere für die in das Halbleitersubstrat einzubringenden Phosphoratome dienen. Bei den verwendeten hohen Diffusionstemperaturen ist eine Dicke der Oxidschicht von 3-5 Mikrometer erforderlich. Die Strukturierung erfolgt auf die Weise, dass im mittleren Bereich des Halbleitersubstrats keine Oxidschicht, an seinem Rand R jedoch eine Oxidschicht verbleibt. Nach diesem Strukturierungsschritt folgen die oben schon beschriebenen Prozessschritte, beginnend mit der Dotierung der n-dotierten Schicht 2.

Ein weiteres Beispiel einer nicht erfindungsgemäßen Halbleiteranordnung 60 ist in Figur 6 schematisch in einem Querschnitt dargestellt. Abweichend von dem Ausführungsbeispiel der Halbleiteranordnung 20 in Figur 2 ist die Teilschicht 2 mit Bor anstatt mit Phosphor dotiert. Im Gegensatz zu der Halbleiteranordnung 20 wird die Sperrspannung UZM in der Mitte der Halbleiteranordnung von dem Übergang zwischen den Teilschichten 2-4 und nicht von dem Übergang zwischen den Teilschichten 3-2 bestimmt.

Grundsätzlich sind auch Ausführungsbeispiele möglich, bei denen das Ausgangsmaterial 1 nicht homogen dotiert vorliegt, sondern als Epitaxieschicht, die auf einem bereits hochdotierten Substrat 4 aufgebracht ist.

Auch wenn in den Figuren jeweils Halbleiterdioden, insbesondere Zenerdioden, dargestellt sind, lässt sich die erfindungsgemäße Lehre auch auf andere Halbleiteranordnungen, die einen pn-Übergang zwischen einer stark dotierten p- und einer stark dotierten n-Schicht mit einer nachgelagerten, schwächer dotierten n-Schicht übertragen. Ebenso sind Halbleiterbauelemente möglich, bei denen alle p-und n-Schichten miteinander vertauscht sind.

## Patentansprüche

1. Halbleiteranordnung mit einem pn-Übergang, die mit einem Randbereich ausgebildet ist, mit einer zweiten Teilschicht (2) die eine zweite Dotierstoffkonzentration und einer ersten Teilschicht (1) die eine erste Dotierstoffkonzentration aufweist, die geringer als die zweite Dotierstoffkonzentration ist, wobei die erste und zweite Teilschicht (1,2) mit einer sich von einer Oberseite erstreckenden dritten Teilschicht (3) einen pn-Übergang bilden, wobei der pn-Übergang der dritten Teilschicht (3) mit der zweiten Teilschicht (2) ausschließlich im Inneren der Halbleiteranordnung und der pn-Übergang zwischen der dritten Teilschicht (3) und der ersten Teilschicht (1) im Randbereich der Halbleiteranordnung ausgebildet ist, und wobei die Halbleiteranordnung eine von der Rückseite erstreckende vierte Teilschicht (4) umfasst, die eine vierte Dotierstoffkonzentration aufweiset, die höher ist als die zweite Dotierstoffkonzentration und wesentlich höher als die erste Dotierstoffkonzentration, wobei die erste, zweite und vierte Teilschicht vom gleichen Leitfähigkeitstyp sind, wobei die vierte Teilschicht (4) über den größten Teil einer Querschnittsfläche (BC) im Inneren der Halbleiteranordnung (20,30,) unmittelbar an die zweite Teilschicht (2) und nur in einem vergleichsweise schmalen Randbereich der Querschnittsfläche (BC) an die erste Teilschicht (1) angrenzt, wobei sich die zweite und vierte Teilschicht (2, 4) der Halbleiteranordnung (20, 30,60) in einem mittleren Bereich der Halbleiteranordnung (20, 30,60) wenigstens berühren, vorzugsweise aber bereichsweise überlappen, wobei die Oberseite der Halbleiteranordnung im Randbereich einen breiten, flachen Sägegraben mit einer Sägebreite (SB) und einer Sägetiefe (ST) aufweist, wobei die Sägebreite (SB) größer als 80 Mikrometer, vorzugsweise größer als 100 Mikrometer ist, und wobei das Verhältnis von Sägebreite (SB) zu Sägetiefe (ST) einen Wert > 3 hat.

2. Halbleiteranordnung nach einem der vorhergehenden Ansprüche, **dadurch gekennzeichnet, dass** der Sägegraben (SB, ST) derart vollständig mit Lotmaterial gefüllt ist, dass die Wandflächen des Sägegrabens mit Lotmaterial bedeckt und durch dieses Lotmaterial geschützt sind.

3. Halbleiteranordnung nach einem der vorhergehenden Ansprüche ausgebildet als elektrisches Ventil, insbesondere Diode.

4. Halbleiteranordnung nach einem der vorhergehenden Ansprüche, **dadurch gekennzeichnet, dass** die Dotierung der ersten Teilschicht (1) am Rand der Halbleiteranordnung geringer ist als die Dotierung der zweiten Teilschicht (2) in der Mitte, wodurch die Durchbruchsspannung (UZR) im Randbereich der Halbleiteranordnung (20, 30, 60) wesentlich größer ist als die Durchbruchsspannung (UZM) in einem mittleren Bereich der Halbleiteranordnung (20,30,60).

5. Verfahren zur Herstellung einer Halbleiteranordnung nach einem der Ansprüche 1 bis 4, **gekennzeichnet durch** folgende Verfahrensschritte:
- Herstellen eines eine erste Teilschicht (1) einer Halbleiteranordnung (20, 30) bildenden Halbleitersubstrats eines ersten Leitfähigkeitstyps,
- beidseitiges Dotieren des Halbleitersubstarts zur Bildung einer zweiten und einer vierten Teilschicht (2,4) des gleichen Leitfähigkeitstyps wie die ersten Teilschicht (1) aber mit unterschiedlichen Dotierungsgraden, wobei nach einem oberflächlichen Eintreiben der Dotierstoffe im Randbereich der Halbleitervorrichtung ein breiter, flacher Sägegraben mit einer Sägebreite (SB) und einer Sägetiefe (ST) eingebracht wird, wobei die Sägebreite (SB) größer als 80 Mikrometer, vorzugsweise größer als 100 Mikrometer ist, und wobei das Verhältnis von Sägebreite (SB) zu Sägetiefe (ST) einen Wert > 3 hat und anschließend ein Diffusionsvorgang erfolgt derart, dass sich die zweite und vierte Teilschicht (2, 4),
- höchstens in einem mittleren Bereich der Halbleiteranordnung (20,30) berühren oder überlappen, und das Halbleitersubstrat im Randbereich die erste Teilschicht (1) mit einer geringeren Dotierkonzentration als die zweite und vierte Teilschicht (2, 4) bildet,
- Erzeugung einer dritten Teilschicht (3) eines entgegengesetzten Leitungstyps **durch** Einbringen eines Dotierstoffes in die erste und zweite Teilschicht (1, 2), sowie Erhöhung der Dotierkonzentration der vierten Teilschicht (4),
- Bedecken der äußeren Oberflächen der dritten Teilschicht (3) und der vierten Teilschicht (4) mit metallischen Kontaktschichten (5,6).

## Claims

1. Semiconductor arrangement comprising a pn junction, which semiconductor arrangement is embodied with an edge region, comprising a second partial layer (2) having a second dopant concentration, and a first partial layer (1) having a first dopant concentration, which is lower than the second dopant concentration, wherein the first and second partial layers (1, 2) together with a third partial layer (3) extending from a top side form a pn junction, wherein the pn junction between the third partial layer (3) and the second partial layer (2) is embodied exclusively in the interior of the semiconductor arrangement and the pn junction between the third partial layer (3) and the first partial layer (1) is embodied in the edge region of the semiconductor arrangement, and wherein the semiconductor arrangement comprises a fourth partial layer (4) extending from the rear side, said fourth partial layer having a fourth dopant concentration, which is higher than the second dopant concentration and significantly higher than the first dopant concentration, wherein the first, second and fourth partial layers are of the same conductivity type, wherein the fourth partial layer (4) directly adjoins the second partial layer (2) over the majority of a cross-sectional area (BC) in the interior of the semiconductor arrangement (20, 30) and adjoins the first partial layer (1) only in a comparatively narrow edge region of the cross-sectional area (BC), wherein the second and fourth partial layers (2, 4) of the semiconductor arrangement (20, 30, 60) at least touch, but preferably overlap regionally, in a central region of the semiconductor arrangement (20, 30, 60), wherein the top side of the semiconductor arrangement comprises in the edge region a wide, shallow soaring trench having a soaring width (SB) and a soaring depth (ST), wherein the soaring width (SB) is greater than 80 micrometres, preferably greater than 100 micrometres, and wherein the ratio of soaring width (SB) to soaring depth (ST) has a value > 3.

2. Semiconductor arrangement according to any of the preceding claims, **characterized in that** the soaring trench (SB, ST) is filled completely with solder material in such a way that the wall surfaces of the soaring trench are covered with solder material and protected by said solder material.

3. Semiconductor arrangement according to any of the preceding claims embodied as an electrical valve, in particular diode.

4. Semiconductor arrangement according to any of the preceding claims, **characterized in that** the doping of the first partial layer (1) at the edge of the semiconductor arrangement is lower than the doping of the second partial layer (2) in the centre, as a result of which the breakdown voltage (UZR) in the edge region of the semiconductor arrangement (20, 30, 60) is significantly greater than the breakdown voltage (UZM) in a central region of the semiconductor arrangement (20, 30, 60).

5. Method for producing a semiconductor arrangement according to any of Claims 1 to 4, **characterized by** the following method steps:
- producing a semiconductor substrate of a first conductivity type, said semiconductor substrate forming a first partial layer (1) of a semiconductor arrangement (20, 30),
- doping the semiconductor substrate on both sides in order to form a second and a fourth partial layer (2, 4) of the same conductivity type as the first partial layer (1) but with different degrees of doping, wherein after a superficial drive in of the dopants in the edge region of the semiconductor device, a wide, shallow soaring trench having a soaring width (SB) and a soaring depth (ST) is introduced, wherein the soaring width (SB) is greater than 80 micrometres, preferably greater than 100 micrometres, and wherein the ratio of soaring width (SB) to soaring depth (ST) has a value > 3, and a diffusion process is subsequently effected in such a way that the second and fourth partial layers (2, 4)
- touch or overlap at most in a central region of the semiconductor arrangement (20, 30) and the semiconductor substrate in the edge region forms the first partial layer (1) having a lower doping concentration than the second and fourth partial layers (2, 4),
- producing a third partial layer (3) of an opposite conductivity type by introducing a dopant into the first and second partial layers (1, 2) and increasing the doping concentration of the fourth partial layer (4),
- covering the outer surfaces of the third partial layer (3) and the fourth partial layer (4) with metallic contact layers (5, 6).

## Revendications

1. Système semi-conducteur comportant une transition pn qui est réalisée avec une zone de bord, comportant une deuxième couche partielle (2) qui présente une deuxième concentration de matériau dopant et une première couche partielle (1) qui présente une première concentration de matériau dopant inférieure à la deuxième concentration de matériau dopant, dans lequel les première et deuxième couches partielles (1, 2) forment une transition pn avec une troisième couche partielle (3) s'étendant depuis une face supérieure, dans lequel la transition pn de la troisième couche partielle (3) avec la deuxième couche partielle (2) est exclusivement formée à l'intérieur du système semi-conducteur et la transition pn entre la troisième couche partielle (3) et la première couche partielle (2) est formée dans la zone de bord du système semi-conducteur, et dans lequel le système semi-conducteur comprend une quatrième couche partielle (4) s'étendant depuis la face arrière, laquelle quatrième couche partielle présente une quatrième concentration de matériau dopant qui est supérieure à la deuxième concentration de matériau dopant et est sensiblement supérieure à la première concentration de matériau dopant, dans lequel les première, deuxième et quatrième couches partielles ont le même type de conductivité, dans lequel la quatrième couche partielle (4) est adjacente sur la plus grande partie d'une surface en section transversale (BC), à l'intérieur du système semi-conducteur (20, 30), immédiatement adjacente à la deuxième couche partielle (2) et n'est adjacente que dans une zone de bord relativement étroite de la surface en section transversale (BC) à la première couche partielle (1), dans lequel les deuxième et quatrième couches partielles (2, 4) du système semi-conducteur (20, 30, 60) sont au moins en contact dans une zone centrale du système semi-conducteur (20, 30, 60), mais se superposent de préférence dans certaines zones, dans lequel la face supérieure du système semi-conducteur présente, dans la zone de bord, une tranchée de sciage large et plane ayant une largeur de sciage (SB) et une profondeur de sciage (ST), dans lequel la largeur de sciage (SB) est supérieure à 80 micromètres et de préférence, supérieure à 100 micromètres, et dans lequel le rapport de la largeur de sciage (SB) à la profondeur de sciage (ST) a une valeur supérieure à 3.

2. Système semi-conducteur selon l'une quelconque des revendications précédentes, **caractérisé en ce que** la tranchée de sciage (SB, ST) est entièrement remplie de matériau de soudage de manière à ce que les surfaces de parois de la tranchée de sciage soient recouvertes par le matériau de soudage et soient protégées par ledit matériau de soudage.

3. Système semi-conducteur selon l'une quelconque des revendications précédentes, **caractérisé en ce qu'**elle est réalisée sous la forme d'une soupape électrique, notamment d'une diode.

4. Système semi-conducteur selon l'une quelconque des revendications précédentes, **caractérisé en ce que** le dopage de la première couche partielle (1) sur le bord du système à semi-conducteur est inférieur au dopage de la deuxième couche partielle (2) en son centre, dans lequel la tension de claquage (UZR) dans la zone de bord du système semi-conducteur (20, 30, 60) est sensiblement supérieure à la tension de claquage (UZM) dans une zone centrale du système semi-conducteur (20, 30, 60).

5. Procédé de fabrication d'un système semi-conducteur selon l'une quelconque des revendications 1 à 4, **caractérisé par** les étapes consistant à :
- réaliser un substrat semi-conducteur ayant un premier type de conductivité formant une première couche (1) d'un système semi-conducteur (20, 30),
- doper les deux faces du substrat semi-conducteur pour former des deuxième et quatrième couches partielles (2, 4) ayant le même type de conductivité que la première couche partielle (1) mais des degrés de dopage différents, dans lequel, après introduction du matériau dopant dans la zone de bord du dispositif semi-conducteur, une tranchée de sciage large et plane ayant une largeur de sciage (SB) et une profondeur de sciage (ST) est créée, dans lequel la largeur de sciage (SB) est supérieure à 80 micromètres et de préférence supérieure à 100 micromètres, et dans lequel le rapport de la largeur de sciage (SB) à la profondeur de sciage (ST) a une valeur supérieure à 3, et un processus de diffusion est ensuite réalisé de manière à ce que les deuxième et quatrième couches partielles (2, 4),
- soient en contact ou se chevauchent au plus dans une zone centrale du système semi-conducteur (20, 30), et le substrat semi-conducteur forme, dans la zone de bord, la première couche partielle (1) avec une plus faible concentration de dopant que les deuxième et quatrième couches partielles (2, 4),
- générer une troisième couche partielle (3) ayant un type de conductivité opposé par introduction d'un matériau dopant dans les première et deuxième couches partielles (1, 2), et augmenter la concentration de dopant de la quatrième couche partielle (4),
- recouvrir la surface extérieure de la troisième couche partielle (3) et de la quatrième couche partielle (4) de couches de contact métalliques (5, 6).
